# EUROPEAN PATENT APPLICATION

(11) **EP 2 775 531 A1**
(43) Date of publication of application: **10.09.2014**
(21) Application number: 13158139.9
(22) Date of filing: 07.03.2013
(51) Int. Cl.: H01L 31/02

(54) **Method and arrangement for operating photovoltaic system and photovoltaic system**

(71) Applicant: ABB Oy, 00380 Helsinki (FI)
(72) Inventor: Puukko, Joonas, 00380 Helsinki (FI); Nousiainen, Lari, 00380 Helsinki (FI)
(74) Representative: Kolster Oy Ab

(57) **Abstract**

A method and an arrangement for operating a photovoltaic system, and a photovoltaic system comprising a boost converter (10A, 10B) having a controllable duty ratio, at least two strings (20) of photovoltaic panels supplying an input of the boost converter (10A, 10B), wherein the strings are connected in parallel with each other, detection means (30, 31) configured to detect a reverse current in any of the strings (20), and control means (40) configured to increase, in response to the detection means detecting a reverse current in at least one of the strings (20), the duty ratio of the boost converter (10A, 10B) at least insomuch that the reverse current stops.

## Description

### FIELD OF THE INVENTION

The invention relates to a method for operating a photovoltaic system, an arrangement for controlling a photovoltaic system, and to a photovoltaic system.

### BACKGROUND OF THE INVENTION

Photovoltaic generators may comprise two or more parallel-connected strings of photovoltaic (PV) panels (consisting of one or more photovoltaic modules) which supply a common power converter, for example. If one of such parallel-connected strings becomes passive, i.e. its open circuit voltage drops owing to heavy shading of PV panels or a fault, for example, it may start absorbing and dissipating electric power generated by the other strings connected in parallel to the same power converter through a current which flows through the string under consideration in a reverse direction with respect to that of normal operation. Accordingly, such a current flowing in the reverse direction with respect to that of the normal operation is called a reverse current.

The reverse current can reach high values, especially when there is a large number of strings connected in parallel. The PV panels may be unable to withstand this sort of current and, in the absence of protection devices, they may develop faults within a very short time. The reverse current may also even cause a risk of fire. Thus, the reverse current is a highly undesirable phenomenon.

One possible protection method against the reverse current is to use so-called reverse cut-off diodes connected in series with the individual strings to prevent any reverse current in the corresponding string. A disadvantage related to the use of reverse cut-off diodes is that the diode is always connected in series to the corresponding string, whereby the string current always flows through it and may lead to high continuous power losses owing to the effect of the voltage drop on the diode junction. The use of diodes also causes additional costs.

Another possible protection method against the reverse current is to use fuses connected in series with the individual strings. Fuses can limit the reverse current in the corresponding string to the permitted maximum. The losses at such fuses are typically significantly lower than those of the reverse cut-off diodes. The use of fuses may not, however, completely prevent the reverse current from circulating in the strings. The use of fuses also causes additional costs.

Yet another possible protection method against the reverse current is to use automatic miniature circuit breakers connected in series with the individual strings. A disadvantage related to the use of circuit breakers is that they cause additional costs which may be even higher than the cost of diodes or fuses.

US 2012/0139347 discloses a solution to protect strings of photovoltaic modules feeding an inverter against the occurrence of reverse currents. The suggested solution includes controlling the inverter to reduce system voltage between bus lines at an input of the inverter. Further an additional discharging resistor is used to discharge the buffer capacitance of the inverter.

### BRIEF DESCRIPTION OF THE INVENTION

The object of the invention is thus to provide a method and an apparatus for implementing the method so as to solve or at least alleviate the above problem or at least to provide an alternative solution. The object of the invention is achieved with a method, a computer program product, an arrangement, and a system that are characterized by what is stated in the independent claims. Preferred embodiments of the invention are described in the dependent claims.

The invention is based on the idea of increasing, in response to detecting a reverse current in one or more strings of a photovoltaic system comprising at least two strings of photovoltaic panels supplying an input of a boost converter, the duty ratio of the boost converter at least insomuch that the reverse current stops.

An advantage of the solution of the invention is that the photovoltaic system can be effectively protected against reverse currents and the solution of the invention may be realized without any additional devices.

### BRIEF DESCRIPTION OF THE FIGURES

In the following, the invention will be described in more detail in connection with preferred embodiments and with reference to the accompanying drawings, in which
Figure 1 illustrates an example of a photovoltaic system according to an embodiment;
Figure 2 illustrates an example of a boost converter according to an embodiment; and
Figure 3 illustrates current, voltage and duty ratio according to an embodiment.

### DETAILED DESCRIPTION OF THE INVENTION

The application of the invention is not limited to any specific system, but it can be used in connection with various electric systems. Moreover, the use of the invention is not limited to systems employing any specific fundamental frequency or any specific voltage level.

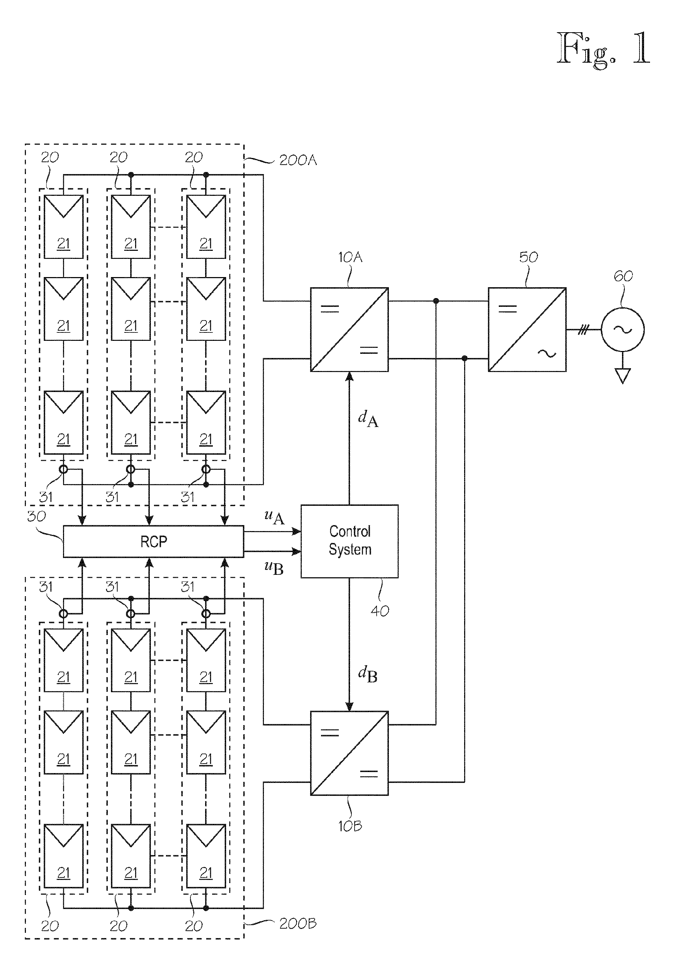

Figure 1 illustrates an example of a photovoltaic system. The figure shows only components necessary for understanding the invention. The exemplary system of Figure 1 comprises two photovoltaic generators 200A, 200B each comprising a number of strings 20 of photovoltaic panels 21, wherein the strings 20 within a photovoltaic generator 200A, 200B are connected in parallel with each other. A string 20 comprises a number of photovoltaic panels 21 connected in series with each other. Each of the photovoltaic panels 21 may comprise one or more photovoltaic modules. The exemplary system of Figure 1 further comprises two boost converters (step-up converters) 10. The term 'boost converter' herein generally refers to a converter device that provides an output voltage greater than its input voltage and consequently an output current lower than its input current. Each of the photovoltaic generators 200A, 200B supplies an input of a respective boost converter 10A, 10B. The purpose of the boost converters 10A, 10B is to raise the voltage supplied by the photovoltaic generators 200A, 200B and to lower the current supplied by the photovoltaic generators 200A, 200B, or in other words, to transfer the power produced by the photovoltaic generators 200A, 200B to a higher voltage level than the operating voltage of the photovoltaic generators. The boost converters 10A, 10B, in turn, may supply an inverter 50, which can be used to convert the DC power supplied by the boost converters 10A, 10B into AC power which can then be supplied further to a three-phase AC power network 60, for example. It should be noted that the number of various system components and elements may vary and differ from that shown in the example of Figure 1. For example, the photovoltaic system could comprise only one photovoltaic generator and only one respective boost converter. Alternatively, the photovoltaic system could comprise more than two photovoltaic generators and more than two respective boost converters.

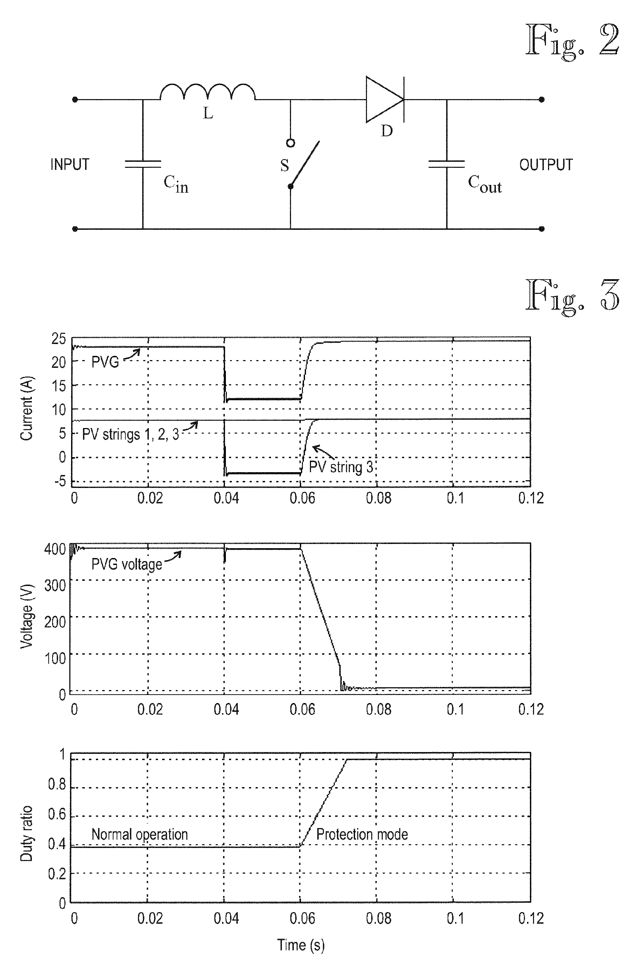

Figure 2 shows an example of a possible main circuit of a boost converter 10A, 10B. It should be noted that the main circuit of a boost converter may differ from that shown in Figure 2. Other types of possible boost converters include a 3-level boost converter and an interleaved boost converter, for example. The main circuit of the boost converter may comprise at least an inductor L, a diode D, and a controllable switch S. The controllable switch S may be a controllable semiconductor switch. The main circuit of the boost converter may further comprise an input capacitor Cin and/or an output capacitor Cout. By suitable control of the switch S, a DC power supplied to the input of the boost converter may be transferred to a higher DC voltage level on the output of the boost converter than the boost converter input DC voltage. The switch S may be triggered periodically with a switching frequency fₛ corresponding to a switching period Tₛ such that fₛ=1/Tₛ. The switching frequency fₛ used depends e.g. on the design of the boost converter and may vary. The boost converter may be controlled by varying its duty ratio. The duty ratio d of the boost converter may be defined as the ratio of the on time tₒₙ of the switch S (the switch is conducting) during a switching period Tₛ to the switching period Tₛ, i.e. d=tₒₙ/Tₛ, and it may vary from 0 to 1 (0 to 100%).

According to an embodiment, a reverse current is first detected in at least one of the strings. For this the photovoltaic system may comprise suitable detection means configured to detect a reverse current in any of the strings 20. In the example of Figure 1 such means include current sensors 31 in connection with each of the strings 20 and a protection logic unit 30 (RCP, reverse current protection) which processes the signals from the current sensors 31. The current sensors 31 are preferably at least able to detect when a reverse current flows in the respective string 20 that the current sensor 31 is connected to and report this to the protection logic unit 30. Instead of having a current sensor 31 in connection with each of the strings 20, it is alternatively possible to have current sensors (not shown) connected in the connections between the strings 20. Such current sensors can then monitor the current between the strings 20 and report this to the protection logic unit 30. The protection logic unit 30 can then deduce from the received current information if a reverse current flows in one or more of the strings 20.

According to an embodiment, the duty ratio of the boost converter is increased, in response to the detecting of the reverse current in the at least one of the strings, at least insomuch that the reverse current stops. For this the photovoltaic system may further comprise suitable control means configured to increase, in response to the detection means detecting a reverse current in at least one of the strings 20, the duty ratio of the boost converter at least insomuch that the reverse current stops. In the example of Figure 1 such means include a control system unit 40. Upon detecting a reverse current in one or more of the strings 20, The protection logic unit 30 preferably notifies the control system unit 40 about the detection of the reverse current. In the example of Figure 1, the protection logic unit 30 sends signal u_{A} to the control system unit 40 when a reverse current is detected in one or more of the strings of the first photovoltaic generator 200A and signal u_{B} when a reverse current is detected in one or more of the strings of the second photovoltaic generator 200B. In response to receiving signal u_{A}, the control system unit 40 increases the duty ratio of the first boost converter 10A by sending a control signal d_{A} to the first boost converter 10A. In a similar manner, in response to receiving signal u_{B}, the control system unit 40 increases the duty ratio of the second boost converter 10B by sending a control signal d_{B} to the second boost converter 10B. The duty ratio of the boost converter is preferably increased at least insomuch that the reverse current stops. In the example of Figure 1, the control system unit 40 thus increases the duty ratio of the boost converter 10A, 10B in question until the protection logic unit 30 no longer reports a reverse current in any of the strings 20 of the respective photovoltaic generator 200A, 200B. As a result of the sufficient increase in the duty ratio of the boost converter 10A, 10B, the occurrence of the reverse current can be removed. If the duty ratio of the boost converter of the photovoltaic generator affected by the reverse current after the increase of said duty ratio to the point at which the reverse current is stopped is still below 100%, it is possible to continue to supply power from the affected photovoltaic generator, if desired.

According to an embodiment, the duty ratio of the boost converter 10A, 10B is increased gradually. Such a gradual increase of the duty ratio of the boost converter 10A, 10B allows a possible input capacitance Cin of the boost converter to discharge without causing a high current pulse. As a result, no additional discharge circuit is needed. The gradual increase of the duty ratio of the boost converter 10A, 10B may be performed by increasing the duty ratio of the boost converter in a ramp-like manner, for example.

According to an embodiment, the duty ratio of the boost converter 10A, 10B is increased to 100% in response to the detecting of the reverse current in the at least one of the strings 20. When the duty ratio of the boost converter is 100%, the switch S is always on and, thus, the poles of the input of the boost converter 10A, 10B are essentially in short-circuit with each other. As a result, all the strings 20 of the respective photovoltaic generator 200A, 200B connected to the boost converter 10A, 10B in question are essentially in short-circuit through the boost converter 10A, 10B, whereby no reverse current flows through any of the strings anymore. In the exemplary system of Figure 1, when only one of the two photovoltaic generators 200A, 200B has a reverse current situation in one or more of its strings and the respective boost converter has a duty ratio of 100%, the remaining healthy photovoltaic generator may still continue to supply power to the inverter 50.

According to an embodiment, in response to the detecting of the reverse current in at least one of the strings, a fault signal is sent to an operator of the photovoltaic system. Such a fault signal may be sent by the protection logic unit 30 or the control system unit 40, for example. For example, in the exemplary system of Figure 1, signals u_{A} and u_{B} may be utilized for this purpose. Such a fault signal may be used as an additional safety measure in order to ensure the safe operation of the photovoltaic system.

Figure 3 shows simulation results of a system corresponding to Figure 1, when the first photovoltaic generator 200A has three strings 20 of photovoltaic panels 21, each string having 16 panels, and of which strings one develops a reverse current situation. Figure 3 shows the currents of the three strings 1, 2, and 3 as well as the total current of the photovoltaic generator, the voltage of the photovoltaic generator, and the duty ratio of the respective first boost converter 10A. At time t=0.04 s one of the strings (string 3) is affected by a short-circuit of six PV panels and, as a result, the remaining two strings (1 and 2) begin to feed the faulty string. Thus, the current of PV string 3 becomes negative, i.e. reverse current. The protection functions at time t=0.06 s (transition from normal operation to protection mode) and the duty ratio of the first boost converter 10A is increased gradually in a ramp-like manner to 100% as shown in the figure. From the simulation results it can be seen that all three strings are driven in short-circuit (the voltage of the photovoltaic generator becomes zero) and thus their currents start to circulate through the switch of the first boost converter 10A and the reverse current situation is cleared. The switches of the boost converters are typically readily designed to withstand the short-circuit current of the photovoltaic generators connected thereto, whereby there is typically no reason to oversize the boost converters in order to utilize any of the above-described embodiments. As can be seen from the simulation results, no current pulse results from the increase of the duty ratio of the boost converter when the duty ratio is increased gradually.

The protection logic unit 30 and the control system unit 40 or other control means controlling the boost converter 10A, 10B according to any one of the above embodiments, or a combination thereof, may be implemented as one physical unit or as two or more separate physical units that are configured to implement the functionality of the various embodiments. Herein the term 'unit' generally refers to a physical or logical entity, such as a physical device or a part thereof or a software routine. The protection logic unit 30 and the control system unit 40 according to any one of the embodiments may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations, and a central processing unit (CPU), such as a general-purpose digital signal processor. The CPU may comprise a set of registers, an arithmetic logic unit, and a control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention, or a part thereof, may further comprise suitable input means for receiving e.g. measurement and/or control data, and output means for outputting e.g. control or other data. It is also possible to use a specific integrated circuit or circuits, or discrete electric components and devices for implementing the functionality according to any one of the embodiments.

The invention can be implemented in existing boost converters. Present boost converters may comprise processors and memory that can be utilized in the functions according to the various embodiments described above. Present photovoltaic systems may also readily comprise means for measuring the string currents, thus enabling them to detect a reverse current in strings of PV panels without any additional measuring equipment. Thus, all modifications and configurations required for implementing an embodiment in existing boost converters may be performed as software routines, which may be implemented as added or updated software routines. If at least part of the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory, e.g. a flash memory or an optical memory, from which it is loadable to the unit or units executing the program code. In addition, such a computer program code implementing the invention may be loaded to the unit or units executing the computer program code via a suitable data network, for example, and it may replace or update a possibly existing program code.

It is obvious to a person skilled in the art that as technology advances, the basic idea of the invention can be implemented in a variety of ways. Consequently, the invention and its embodiments are not restricted to the above examples, but can vary within the scope of the claims.

## Claims

1. A method for operating a photovoltaic system comprising:
a boost converter (10A, 10B) having a controllable duty ratio; and
at least two strings (20) of photovoltaic panels supplying an input of the boost converter (10A, 10B), wherein the strings are connected in parallel with each other, the method comprising:
detecting a reverse current in at least one of the strings (20), **characterized in that** the method comprises:
increasing, in response to the detecting of the reverse current in the at least one of the strings (20), the duty ratio of the boost converter (10A, 10B) at least insomuch that the reverse current stops.

2. A method as claimed in claim 1, **characterized in that** the duty ratio of the boost converter (10A, 10B) is increased gradually.

3. A method as claimed in claim 2, **characterized in that** the duty ratio of the boost converter (10A, 10B) is increased in a ramp-like manner.

4. A method as claimed in claim 1, 2 or 3, **characterized in that** the duty ratio of the boost converter (10A, 10B) is increased to 100% in response to the detecting of the reverse current in the at least one of the strings (20).

5. A method as claimed in claim 4, **characterized in that** when the duty ratio of the boost converter (10A, 10B) is 100%, poles of the input of the boost converter are essentially in short circuit with each other.

6. A method as claimed in any one of claims 1 to 5, **characterized in that** the string (20) comprises photovoltaic panels (21) connected in series with each other.

7. A method as claimed in any one of claims 1 to 6, **characterized in that** the method comprises sending, in response to the detecting of the reverse current in at least one of the strings (20), a fault signal to an operator of the photovoltaic system.

8. A computer program product comprising computer program code, wherein execution of the program code in a computer causes the computer to carry out the steps of the method according to any one of claims 1 to 7.

9. An arrangement for controlling a photovoltaic system comprising a boost converter (10A, 10B) having a controllable duty ratio, and at least two strings (20) of photovoltaic panels supplying an input of the boost converter (10A, 10B), wherein the strings are connected in parallel with each other, the arrangement comprising:
detection means (30, 31) configured to detect a reverse current in any of the strings (20), **characterized in that** the arrangement comprises:
control means (40) configured to increase, in response to the detection means detecting a reverse current in at least one of the strings (20), the duty ratio of the boost converter (10A, 10B) at least insomuch that the reverse current stops.

10. An arrangement as claimed in claim 9, **characterized in that** the control means (40) are configured to increase the duty ratio of the boost converter (10A, 10B) gradually.

11. An arrangement as claimed in claim 10, **characterized in that** the control means (40) are configured to increase the duty ratio of the boost converter (10A, 10B) in a ramp-like manner.

12. An arrangement as claimed in claim 9, 10 or 11, **characterized in that** the control means (40) are configured to increase the duty ratio of the boost converter (10A, 10B) to 100% in response to the detection means detecting a reverse current in at least one of the strings (20).

13. An arrangement as claimed in claim 12, **characterized in that** when the duty ratio of the boost converter (10A, 10B) is 100%, poles of the input of the boost converter are essentially in short circuit with each other.

14. An arrangement as claimed in any one of claims 9 to 13, **characterized in that** the string (20) comprises photovoltaic panels (21) connected in series with each other.

15. An arrangement as claimed in any one of claims 9 to 14, **characterized in that** the system comprises sending means configured to send, in response to the detection means detecting a reverse current in at least one of the strings (20), a fault signal to an operator of the photovoltaic system.

16. A photovoltaic system comprising:
a boost converter (10A, 10B) having a controllable duty ratio;
at least two strings (20) of photovoltaic panels supplying an input of the boost converter (10A, 10B), wherein the strings are connected in parallel with each other; and
the arrangement according to any one of claims 9 to15.
